# EUROPEAN PATENT SPECIFICATION

(11) **EP 4 266 352 B1**
(45) Date of publication and mention of the grant of the patent: **07.01.2026**
(21) Application number: 21919743.1
(22) Date of filing: 27.12.2021
(51) Int. Cl.: H01L 21/78, H01L 21/308, H01L 21/3065

(54) **PROTECTIVE FILM FORMATION AGENT, AND PRODUCTION METHOD FOR SEMICONDUCTOR CHIP**
SCHUTZSCHICHTBILDUNGSMITTEL UND HERSTELLUNGSVERFAHREN FÜR HALBLEITERCHIP
AGENT DE FORMATION DE FILM PROTECTEUR, ET PROCÉDÉ DE PRODUCTION DE PUCE EN SEMI-CONDUCTEUR

(30) Priority: 14.01.2021 JP 2021004273
(43) Date of publication of application: 25.10.2023
(73) Proprietor: TOKYO OHKA KOGYO CO., LTD., Kawasaki-shi, Kanagawa 211 0012 (JP)
(72) Inventor: KINOSHITA Tetsuro, Kawasaki-shi, Kanagawa 211-0012 (JP); SHIBUTA Yusuke, Kawasaki-shi, Kanagawa 211-0012 (JP)
(74) Representative: Plasseraud IP
(86) International application number: PCT/JP2021/048546
(87) International publication number: WO 2022/153858

(56) References cited:
- WO-A1-2020/100403
- JP-A- 2016 066 768
- JP-A- 2018 174 310
- JP-A- 2019 212 764
- JP-A- 2019 212 765
- JP-A- 2020 066 665
- JP-A- 2020 066 666

## Description

### TECHNICAL FIELD

The present invention relates to a protective film forming agent and a method of manufacturing a semiconductor chip using this protective film forming agent.

### BACKGROUND ART

A wafer formed in a semiconductor device manufacturing step has a laminate in which an insulating film and functional film are laminated on the surface of a semiconductor substrate such as silicon, and is demarcated by a lattice of scheduled division lines called streets, and the respective regions demarcated by the streets define semiconductor chips such as IC and LSI.

A plurality of semiconductor chips are obtained by cutting the wafer along these streets. In addition, an optical device wafer has a laminate in which a gallium nitride-based compound semiconductor or the like is laminated, and is demarcated into a plurality of regions by the streets. By cutting along these streets, the optical device wafer is divided into optical devices such as light emitting diodes or laser diodes. These optical devices are widely applied to electrical equipment.

Such cutting along the streets of a wafer has been carried out in the past by a cutting device called a dicer. However, since a wafer having a laminate structure is a highly brittle material, this method has had a problem in that at the time of cutting to divide the wafer into semiconductor chips or the like by a cutting blade (cutting edge), e.g. scratches or chipping occurs, causing the insulating film required as a circuit element formed on the chip surface to peel.

In order to avoid such flaws, the following method has been proposed in which a mask containing a layer of water-soluble material is formed on the surface of a semiconductor substrate, and next, the mask is irradiated with a laser to decompose and remove a part of the mask, whereby the surface of the semiconductor substrate is exposed at parts of the mask, and subsequently, the semiconductor substrate exposed from the parts of the mask is cut by plasma etching to divide the semiconductor substrate into semiconductor chips (IC) (see Patent Document 1).

Patent Document 1: Japanese Unexamined Patent Application (Translation of PCT Application), Publication No. 2014-523112

Documents JP 2019 212765 A, JP 2016 066768 A, JP 2020 066665 A and JP 2019 212764 A disclose further examples for a protective film forming agent comprising a water-soluble resin and a light absorbing agent.

### DISCLOSURE OF THE INVENTION

### Problems to be Solved by the Invention

In this manner, the mask is irradiated with a laser to decompose and remove a part of the mask, whereby a surface of the semiconductor substrate is exposed in the part of the mask, to form a processed groove with a pattern according to a shape of the semiconductor chip. However, when the protective film as a mask is formed using a conventional water-soluble material such as the water-soluble material described in Patent Document 1, there is a problem that the processed groove formed has poor straightness, that is, side walls that constitute the processed groove of the protective film have poor straightness. If the processed groove has poor straightness, semiconductor chips obtained by cutting the semiconductor substrate by plasma etching or the like have poor straightness.

Further, since a fluorine-based gas is generally used in plasma etching, when a protective film is formed using a conventional water-soluble material, there is a problem that the semiconductor substrate may be contaminated by fluorine transmitted through the protective film during the plasma etching.

The present invention has been made in view of the above problems, and an object of the present invention is to provide a protective film forming agent which is used for forming a protective film on a surface of a semiconductor wafer during dicing the semiconductor wafer, which is capable of forming a protective film which allows formation of a processed groove having excellent straightness by laser irradiation, and which has excellent fluorine shielding property, and a method of manufacturing a semiconductor chip using the protective film forming agent.

### Means for Solving the Problems

The present inventors have found that the above problems can be solved by using a protective film forming agent according to claim 1.

A first aspect of the present invention relates to a protective film forming agent according to claim 1.

A second aspect of the present invention relates to a method of manufacturing a semiconductor chip by processing a semiconductor wafer, the method comprising:
forming a protective film by coating the semiconductor wafer with the protective film forming agent according to the first aspect, and
irradiating a predetermined position of one or more layers comprising the protective film on the semiconductor wafer with a laser beam to expose a surface of the semiconductor wafer, and to form a processed groove with a pattern according to a shape of the semiconductor chip.

### Effects of the Invention

According to the present invention, in a method of manufacturing a semiconductor chip for manufacturing a semiconductor chip from a semiconductor wafer, it is possible to provide a protective film forming agent which is used for forming a protective film on a surface of the semiconductor wafer, which is capable of forming a protective film which allows formation of a processed groove having excellent straightness by laser irradiation, and which has excellent fluorine shielding property, and a method of manufacturing a semiconductor chip using the protective film forming agent.

### BRIEF DESCRIPTION OF THE DRAWINGS

FIG. 1 is a perspective view showing a semiconductor wafer processed by a method of processing a wafer using the protective film forming agent of the present invention;
FIG. 2 is an enlarged cross-sectional view of the semiconductor wafer shown in FIG. 1;
FIG. 3 is an enlarged cross-sectional view of a main part of a semiconductor wafer on which a protective film has been formed;
FIG. 4 is a perspective view showing a state in which a semiconductor wafer on which the protective film has been formed is supported by an annular frame via protective tape;
FIG. 5 is a perspective view of a main part of a laser processing device by which a step of laser beam irradiation is conducted;
FIG. 6 is an enlarged cross-sectional view of a semiconductor wafer including a protective film and a processed groove formed by laser beam irradiation;
FIG. 7 is an explanatory view showing plasma irradiation on the semiconductor wafer shown in FIG. 6;
FIG. 8 is an enlarged cross-sectional view showing a state in which a semiconductor wafer is divided into semiconductor chips by plasma irradiation; and
FIG. 9 is an enlarged cross-sectional view showing a state in which a protective film on a semiconductor chip has been removed.

### PREFERRED MODE FOR CARRYING OUT THE INVENTION

### <<Protective Film Forming Agent>>

The protective film forming agent is used for forming a protective film on a surface of a semiconductor wafer in dicing the semiconductor wafer. The protective film forming agent includes a water-soluble resin (A), a light absorbing agent (B), and a solvent (S). The water-soluble resin (A) includes a water-soluble resin (A1). The water-soluble resin (A1) has an aromatic ring and a water-soluble group.

Specifically, the protective film forming agent is suitably used to form a protective film in a method for manufacturing a semiconductor chip including: irradiating a protective film formed on a semiconductor wafer with a laser beam to expose the surface of the semiconductor wafer, and to form a processed groove of a pattern according to the shape of the semiconductor chip; and
irradiating the semiconductor wafer including the above protective film and the above processed groove with plasma to process the position of the processed groove on the semiconductor wafer.

Because the removal of the protective film is easy by water washing after processing the semiconductor wafer, and, when performing plasma irradiation in a method of manufacturing a semiconductor chip described later, the durability of the protective film on plasma irradiation is sufficient, typically the thickness of the protective film is preferably 0.1 µm or more and 100 µm or less, and more preferably 1 µm or more and 100 µm or less. In the case of laser irradiation, the thickness of the protective film is preferably 0.1 µm or more and 30 µm or less.

Hereinafter, essential or optional components contained in the protective film forming agent will be explained.

### <Water-Soluble Resin (A)>

The water-soluble resin (A) is a base material of the protective film formed using the protective film forming agent. The water-soluble resin (A) is a resin which can be dissolved in a solvent such as water and coated and dried to form a film. Water solubility means that 0.5 g or more of a solute (water-soluble resin) is dissolved in 100 g of water at 25°C.

The water-soluble resin (A) includes a water-soluble resin (A1) which is a water-soluble resin having an aromatic ring and a water-soluble group. Examples of the aromatic ring having a monocyclic structure include a benzene ring.

The water-soluble group is not particularly limited as long as it is a group capable of imparting water solubility to resins. Examples of the water-soluble group include -SO₃⁻X⁺ (X⁺ is an alkali metal cation, a proton, or N⁺R₄), -COO⁻X⁺ (X⁺ is as described above), a hydroxy group, and an ether bond (-O-). When the hydroxy group is a phenolic hydroxy group, the hydroxy group may form a salt such as an alkali metal salt. It should be noted that R represents a hydrogen atom, an alkyl group, or a hydroxyalkyl group. Examples of the alkali metal include sodium, potassium and strontium.

By including the water-soluble resin (A1) which is a water-soluble resin having an aromatic ring and a water-soluble group, the protective film forming agent can form a protective film which allows formation of a processed groove having excellent straightness by laser irradiation, and which has excellent fluorine shielding property. In this way, by irradiating the protective film formed using the protective film forming agent described above with a laser, a processed groove having excellent straightness can be formed. A semiconductor chip having a cut surface having excellent straightness can be obtained by performing plasma etching on the processed groove having excellent straightness and dividing the wafer along the processed grooves. Further, the protective film formed using the protective film forming agent described above has excellent fluorine shielding property. Therefore, when the protective film is formed using the protective film forming agent, fluorine contamination of the semiconductor substrate due to fluorine-based gas generated during the plasma etching process can be suppressed. On the other hand, when the protective film forming agent does not contain the water-soluble resin (A1), the protective film formed is poor in straightness of the processed groove formed by laser irradiation and the fluorine shielding property.

The water-soluble resin (A1) is a phenol or a polystyrene resin.

Examples of the phenol resins as the water-soluble resin (A1) include resins having a structural unit (constituent unit) represented by the following formula (1). 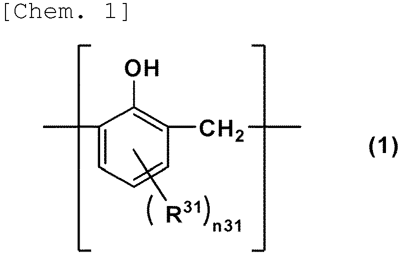 (In the formula (1), R³¹ represents a water-soluble group; and
n31 is an integer of 0 to 3.)
As described above, examples of the water-soluble group include -SO₃⁻X⁺ (X⁺ is an alkali metal cation, a proton, or N⁺R₄), -COO⁻X⁺ (X⁺ is as described above), a hydroxy group, and an ether bond (-O-). When the hydroxy group is a phenolic hydroxy group, the hydroxy group may form a salt such as an alkali metal salt.
n31 is preferably 1. The substitution position of R³¹ in the benzene ring may be any of an ortho position, a meta position, and a para position with respect to OH in the benzene ring.

Specific examples of the phenol resins as the water-soluble resin (A1) include a phenol resin having a structural unit represented by the following formula (1-2), and a phenol resin having a structural unit represented by the following formula (1-1) and a structural unit represented by the following formula (1-2). In the case of the phenol resin having a structural unit represented by the formula (1-1) and a structural unit represented by the formula (1-2), a proportion of the number of moles of the structural unit represented by the formula (1-1) to the total number of moles of the structural unit represented by the formula (1-1) and moles of the structural unit represented by the formula (1-2) is, for example, 0.1 to 0.9, and preferably 0.7 to 0.9. 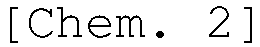 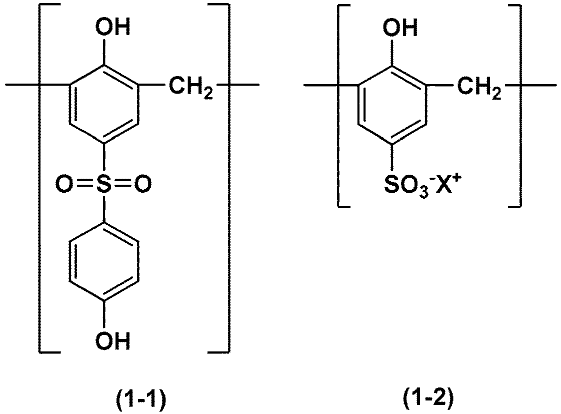 (In the formula, X⁺ represents an alkali metal cation, a proton, or N⁺R₄, and R represents a hydrogen atom, an alkyl group, or a hydroxyalkyl group.)

Examples of the polystyrene resins as the water-soluble resin (A1) include resins having a structural unit represented by the following formula (2). 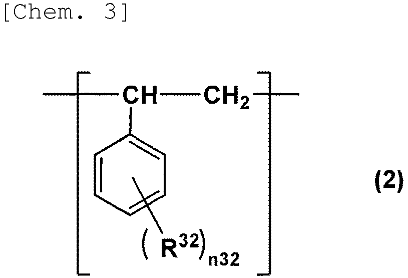 (In the formula (2), R³² represents a water-soluble group; and n32 is an integer of 0 to 3.)
As described above, examples of the water-soluble group include -SO₃⁻X⁺ (X⁺ is an alkali metal cation, a proton, or N⁺R₄), -COO⁻X⁺ (X⁺ is as described above), a hydroxy group, and an ether bond (-O-). When the hydroxy group is a phenolic hydroxy group, the hydroxy group may form a salt such as an alkali metal salt.
n32 is preferably 1. The substitution position of R³² in the benzene ring may be any of an ortho position, a meta position, and a para position.

Examples of the polystyrene resin as the water-soluble resin (A1) include a polystyrene resin having a structural unit represented by the following formula (2-1), and a polystyrene resin having a structural unit represented by the following formula (2-1) and a structural unit represented by the following formula (2-2). 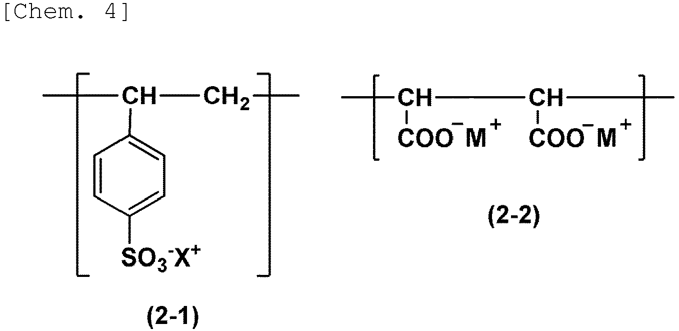
(In the formula, X⁺ is an alkali metal cation, a proton, or N⁺R₄, and R is a hydrogen atom, an alkyl group, or a hydroxyalkyl group;
M⁺ is an alkali metal cation, a proton, or N⁺R⁰¹₄, and R⁰¹ is a hydrogen atom, an alkyl group, or a hydroxyalkyl group; and examples of the alkali metal include sodium, potassium and strontium.)

The mass average molecular weight of the water-soluble resin (A1) is preferably 15,000 or more and 300,000 or less, and more preferably 20,000 or more and 200,000 or less, from the viewpoint of achieving both the decomposability when irradiated with a laser beam (laser light) and the film forming property. In the present specification, the mass average molecular weight is a molecular weight in terms of polystyrene measured by GPC.

The content of the water-soluble resin (A1) in the total solid content of the protective film forming agent is preferably 1% by mass or more and 99% by mass or less, more preferably 1% by mass or more and 60% by mass or less, and most preferably 3% by mass or more and 50% by mass or less from the viewpoint of film forming property. In the present specification, the solid content is a component other than the solvent (S). The content of the water-soluble resin (A1) in the total solid content of the protective film forming agent is preferably 10% by mass or more and 99% by mass or less, and more preferably 10% by mass or more and 50% by mass or less, from the viewpoint of the fluorine shielding property.

The water-soluble resin (A) may contain only the water-soluble resin (A1), or may contain a water-soluble resin other than the water-soluble resin (A1). When the water-soluble resin other than the water-soluble resin (A1) is contained, a ratio of the mass of the water-soluble resin (A1) to the mass of the water-soluble resin (A) is, for example, 1% by mass or more and 90% by mass or less, preferably 1% by mass or more and 70% by mass or less, and more preferably 1% by mass or more and 55% by mass or less. Examples of the water-soluble resin other than the water-soluble resin (A1) (hereinafter also referred to as "other water-soluble resins") include vinyl-based resins, cellulose-based resins, polyethylene oxide, polyglycerin, and water-soluble nylon. The vinyl resin-based is not particularly limited so long as being a homopolymer or copolymer of a monomer having a vinyl group, and being a water-soluble resin. Examples of the vinyl-based resin include polyvinyl alcohol, polyvinyl acetal (including vinyl acetate copolymers), polyvinylpyrrolidone, polyacrylamide, poly(N-alkyl acrylamide), polyallylamine, poly(N-alkyl allylamine), partially amidated polyallylamine, poly(diallylamine), allylamine-diallylamine copolymer, polyacrylic acid, polyvinyl alcohol polyacrylic acid block copolymer, and polyvinyl alcohol polyacrylic acid ester block copolymer. The cellulose-based resin is not particularly limited so long as being a water-soluble cellulose derivative. Examples of the cellulose-based resin include methyl cellulose, ethyl cellulose, hydroxypropyl cellulose, and the like. These can be used individually, or two or more of these can be used in combination.

Among examples of the other water-soluble resins, vinyl-based resins and cellulose-based resins are preferable, and polyvinylpyrrolidone and hydroxypropyl cellulose are more preferable, because deterioration of the shape of the processed groove due to heat sag property of the protective film is less likely to occur. From the viewpoint of film forming property, the cellulose-based resin is preferable.

The protective film formed on the semiconductor wafer surface normally is removed from the surface of the semiconductor wafer or semiconductor chip, at the appropriate moment after formation of the processed groove, according to the method of processing a semiconductor wafer including the protective film and processed groove into semiconductor chips. For this reason, a water-soluble resin having low affinity for the semiconductor wafer surface is preferable from the viewpoint of water washability of the protective film. The water-soluble resin having low affinity for the semiconductor wafer surface is preferably a resin having only an ether bond, hydroxy group, or amide bond as polar groups, for example, polyvinyl alcohol, polyethylene glycol, polyvinylpyrrolidone, and hydroxypropyl cellulose.

The other water-soluble resins preferably have a mass average molecular weight of preferably 15,000 or more and 300,000 or less, and more preferably 20,000 or more and 200,000 or less, from the viewpoint of achieving both the decomposability when irradiated with a laser beam and the film forming property.

Since opening defects upon forming the processed groove by irradiating the protective film with a laser beam, shape deterioration of the processed groove due to heat sagging of the protective film, etc. hardly occur, the ratio of the mass of water-soluble resin (A) relative to the sum of the mass of water-soluble resin (A) and mass of light absorbing agent (B) in the protective film forming agent is preferably 60% by mass or more and 99% by mass or less, and more preferably 80% by mass or more and 95% by mass or less.

### <Light Absorbing Agent (B)>

As the light absorbing agent (B), it is preferred to use a water-soluble dye, a water soluble colorant, and a water soluble light absorbing agent such as a water-soluble ultraviolet absorbing agent. The water-soluble light absorbing agent exists evenly in the protective film and is thus advantageous.

In the case of using a water-soluble light absorbing agent, the storage stability of the protective film forming agent is high, and flaws such as phase separation of the protective film forming agent and precipitation of the light absorbing agent are thus suppressed during storage of the protective film forming agent. Therefore, it is advantageous also from the viewpoint of easily maintaining favorable coatability of the protective film forming agent for a long period.

The light absorbing agent (B) includes a compound represented by the following formula (B1). The compound represented by the following Formula (B1) is preferred because it is capable of efficiently absorbing the energy of a laser beam in the protective film, and promoting the thermal decomposition of the protective film. 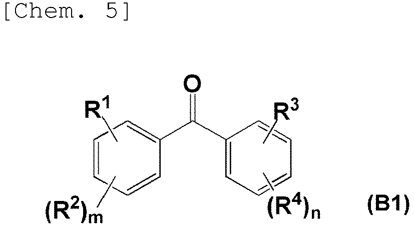 (in Formula (B1), R¹ and R³ are each independently a hydroxy group or a carboxy group, R² and R⁴ are each independently a hydroxy group, a carboxy group or a group represented by - NR⁵R⁶, R⁵ and R⁶ are each independently a hydrogen atom or an alkyl group having 1 or more and 4 or less carbon atoms, and m and n are each independently an integer of 0 or more and 2 or less.)

The compound represented by the above Formula (B1) has a high absorbance index, and exhibits a high absorbance index even in the case of being added to the protective film forming agent together with an alkali. For this reason, when forming a protective film using the protective film forming agent containing a compound represented by the above Formula (B1) as the light absorbing agent (B), it is possible to favorably perform partial decomposition of the protective film by laser when forming a mask for dicing.

In the above Formula (B1), R² and R⁴ may be a group represented by -NR⁵R⁶. R⁵ and R⁶ are each independently a hydrogen atom or an alkyl group having 1 or more and 4 or less carbon atoms. The alkyl group as R⁵ and R⁶ may be a straight chain or a branched chain. Specific examples of the alkyl group as R⁵ and R⁶ include a methyl group, ethyl group, n-propyl group, isopropyl group, n-butyl group, isobutyl group, sec-butyl group and tert-butyl group.

As the group represented by -NR⁵R⁶, an amino group, methylamino group, ethylamino group, dimethylamino group and diethylamino group are preferable, and an amino group, dimethylamino group and diethylamino group are more preferable.

The compound represented by Formula (B1) is preferably a compound represented by the following Formula (B1-1) due to a high absorbance index in the presence of a base: 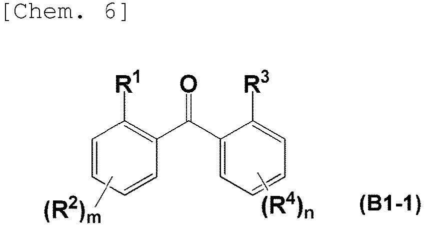 (in Formula (B1-1), R¹ to R⁴, m and n are the same as those in Formula (B1)).

In the above Formula (B1) and Formula (B1-1), at least one of R¹ and R³ is preferably a hydroxy group due to a high absorbance index in the presence of a base.

The compound represented by Formula (B1-1) is preferably a compound represented by any of the following Formulas (B1-1a) to (B1-1e): 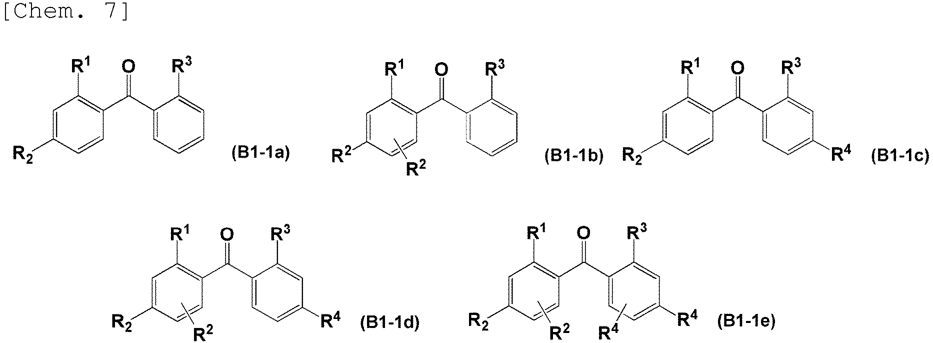 (in Formula (B1-1a) to Formula (B1-1e), R¹ to R⁴ are the same as those in Formula (B1)).

Among the compounds represented by Formula (B1-1a) to Formula (B1-1e), a compound represented by Formula (B1-1a) is preferred. In the compounds represented by Formula (B1-1a) to Formula (B1-1e), preferred are those wherein R² is the aforementioned group represented by -NR⁵R⁶, and R⁵ and R⁶ are each independently an alkyl group having 1 or more and 4 or less carbon atoms.

Suitable specific examples of the compound represented by Formula (B1) include the following compounds. These compounds are preferable due to ease of availability, and a high absorbance index even in the presence of a base.

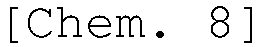

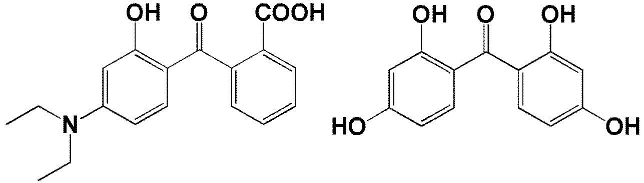

When the light absorbing agent (B) contains a compound represented by Formula (B1), the proportion of the mass of the compound represented by Formula (B1) relative to the mass of light absorbing agent (B) is not particularly limited without impairing the object of the present invention. The proportion of the mass of the compound represented by Formula (B1) relative to the mass of light absorbing agent (B) is preferably 70% by mass or more, more preferably 80% by mass or more, further preferably 95% by mass or more, and particularly preferably 100% by mass.

Examples of the benzophenone-based compound can also include 4,4'-dicarboxybenzophenone, benzophenone-4-carboxylic acid, and tetrahydroxybenzophenone. These are all water soluble ultraviolet absorbing agents.

The amount of the light absorbing agent (B) in the protective film forming agent is not particularly limited without impairing the object of the present invention. The amount of the light absorbing agent (B) in the protective film forming agent is preferably 0.1% by mass or more and 10% by mass or less. Since opening defects upon forming the processed groove by irradiating the protective film with a laser beam, shape deterioration of the processed groove due to heat sagging of the protective film, etc. hardly occur, the ratio of the mass of light absorbing agent (B) relative to the sum of the mass of water-soluble resin (A) and mass of light absorbing agent (B) in the protective film forming agent is preferably 0.1% by mass or more and 50% by mass or less, more preferably 1% by mass or more and 40% by mass or less, and further preferably 2.5% by mass or more and 15% by mass or less. The amount of the light absorbing agent (B) can be set so that the absorbance of the protective film formed by coating the protective film forming agent will have a desired value. The absorbance of the protective film formed by coating the protective film forming agent is not particularly limited, and the absorbance of the protective film formed by coating the protective film forming agent is for example preferably 0.3 or more, more preferably 0.8 or more and further preferably 1.0 or more per 1 µm thickness at a wavelength of 355 nm.

### <Basic Compound (C)>

The protective film forming agent may contain a basic compound (C) for the purpose of facilitating dissolution of the compound represented by Formula (B1). As the basic compound (C), either an inorganic compound or organic compound can be used. As the basic compound (C), an organic compound is preferable. As specific examples of the basic compound (C), it is possible to exemplify basic inorganic compounds such as sodium hydroxide, potassium hydroxide, sodium carbonate, potassium carbonate, sodium silicate, sodium metasilicate and ammonia; and basic organic compounds such as ethylamine, n-propylamine, monoethanolamine, diethylamine, di-n-propylamine, diethanolamine, triethylamine, methyldiethylamine, dimethylethanolamine, triethanolamine, tetramethylammonium hydroxide, tetraethylammonium hydroxide, pyrrole, piperidine, 1,8-diazabicyclo(5,4,0)-7-undecene, and 1,5-diazabicyclo(4,3,0)-5-nonane.

The amount used of the basic compound (C) is not particularly limited in a range not inhibiting the object of the present invention. The amount used of the basic compound (C) relative to 1 mol of the compound represented by Formula (B1), is preferably 1 mol or more, and more preferably 1 mol or more and 20 mol or less. The lower limit for the amount used of the basic compound (C), relative to 1 mol of the compound represented by Formula (B1), may be 1.5 mol or more, may be 2 mol or more, and may be 3 mol or more. The upper limit for the amount used of the basic compound (C), relative to 1 mol of the compound represented by Formula (B1), may be 15 mol or less, may be 10 mol or less, and may be 5 mol or less.

### <Other Additives>

The protective film forming agent may contain other compounding agents unless inhibiting the object of the present invention, in addition to the water-soluble resin (A) and light absorber (B). As the other compounding agent, for example, it is possible to use preservatives, surfactants, etc.

As the preservative, it is possible to use benzoic acid, butylparaben, ethylparaben, methylparaben, propylparaben, sodium benzoate, sodium propionate, benzalkonium chloride, benzethonium chloride, benzyl alcohol, cetylpyridinium chloride, chlorobutanol, phenol, phenylethyl alcohol, 2-phenoxyethanol, phenylmercuric nitrate, thimerosal, metacresol, lauryldimethylamine oxide, and combinations of these.

Using a preservative is preferable not only from the point of preservation of the protective film forming agent, but also the point of a load reduction in the processing of waste liquid after semiconductor wafer washing. A large amount of washing water is generally used for washing of semiconductor wafers. However, in the process using the aforementioned protective film forming agent, proliferation of bacteria in the waste liquid is of concern due to the water-soluble resin (A) contained in the protective film forming agent. For this reason, it is desirable for the waste liquid derived from a process using the aforementioned protective film forming agent to be treated separately from the waste liquid derived from a process not using the protective film forming agent. However, in the case of containing a preservative in the protective film forming agent, since the proliferation of bacteria caused by the water-soluble resin (A) is suppressed, the waste liquid derived from the process using the protective film forming agent and the waste liquid derived from a process not using the protective film forming agent can be treated similarly. For this reason, it is possible to reduce the load of waste-water treatment processing.

The surfactant, for example, is used in order to raise the defoaming property during protective film forming agent production, stability of the protective film forming agent, coatability of the protective film forming agent, etc. In particular, it is preferable to use a surfactant in the point of the defoaming property during protective film forming agent production.

A protective film is generally formed by spin coating the protective film forming agent. However, surface irregularities caused by bubbles may occur upon forming the protective film. In order to suppress the occurrence of such surface irregularities, it is preferable to use an anti-foaming agent such as a surfactant.

As the surfactant, a water-soluble surfactant can be used preferably. As the surfactant, any of nonionic surfactant, cationic surfactant, anionic surfactant and amphoteric surfactant can be used. The surfactant may be silicone based. A nonionic surfactant is preferable from the point of washability.

### <Solvent (S)>

The protective film forming agent usually contains a solvent (S) for dissolving the water-soluble resin (A) and light absorber (B). As the solvent (S), it is possible to use any of water, organic solvent, and an aqueous solution of organic solvent. In the point of little risk of ignition during use, cost, etc., water and an aqueous solution of organic solvent are preferable as the solvent (S), and water is more preferable.

From the viewpoint of flammability, the amount of the organic solvent in the solvent (S) is preferably 30% by mass or less, more preferably 20% by mass or less, further preferably 15% by mass or less.

The solvent (S) is preferably selected so that the protective film forming agent does not have a flash point under 1 atm of pressure. More specifically, by adjusting the content of water in the protective film forming agent, the flash point of the protective film, or presence/absence of a flash point is adjusted. The protective film forming agent without a flash point is safe, for example, and can be left under a non-explosion proof environment. More specifically, it is possible to carry out handling such as storage, transport and use of the protective film forming agent under a non-explosion proof environment. For example, not only the introduction of the protective film forming agent to the semiconductor factory, but also the formation of the protective film can be carried out under a non-explosion proof environment. Therefore, in the point of an explosion proof environment such as a usually expensive explosion proof equipment being unnecessary, the protective film forming agent without a flash point is very advantageous in industry.

The flash point can be obtained by measuring under 1 atm of pressure by the tag closed cup method at a liquid temperature no higher than 80°C, and measured by the Cleveland open cup method at a liquid temperature exceeding 80°C. In the scope of the disclosure and claims of the present application, a case of the flash point not being measurable even when measuring by the Cleveland open cup method is defined as being without a flash point.

Examples of the organic solvent which can be contained in the protective film forming agent include methyl alcohol, ethyl alcohol, alkylene glycol, alkylene glycol monoalkyl ether, alkylene glycol monoalkyl ether acetate, and the like. Examples of the alkylene glycol include ethylene glycol, propylene glycol, and the like. Examples of the alkylene glycol monoalkyl ether include ethylene glycol monomethyl ether, ethylene glycol monoethyl ether, propylene glycol monomethyl ether, propylene glycol monoethyl ether, and the like. Examples of the alkylene glycol monoalkyl ether acetate include ethylene glycol monomethyl ether acetate, ethylene glycol monoethyl ether acetate, propylene glycol monomethyl ether acetate, propylene glycol monoethyl ether acetate, and the like. The protective film forming agent may contain a combination of two or more types of organic solvent.

The solid content concentration of the protective film forming agent is not particularly limited without impairing the object of the present invention. The solid content concentration, for example, is preferably 5% by mass or more and 60% by mass or less, and more preferably 10% by mass or more and 50% by mass or less.

### <<Method of Manufacturing Semiconductor Chip>>

A method of manufacturing a semiconductor chip is a method including a manufacturing of semiconductor chips by processing semiconductor wafers. More specifically, the method of manufacturing a semiconductor chip is a method including: forming a protective film by coating the semiconductor wafer with the aforementioned protective film forming agent; and irradiating a predetermined position of one or more layers including the protective film on the semiconductor wafer with a laser beam to expose the surface of the semiconductor wafer, and to form a processed groove with a pattern according to a shape of the semiconductor chip. Typically, the above manufacturing method of semiconductor chips (the method of manufacturing a semiconductor chip) includes a cutting step of cutting the position of streets on the semiconductor wafer. Hereinafter, forming a protective film is also referred to as "protective film forming step", forming a processed groove is also referred to as "processed groove forming step", and cutting the position of a street in the semiconductor wafer is also referred to as "cutting step".

### <Protective Film Forming Step>

In the protective film forming step, a protective film is formed by coating the semiconductor wafer with the aforementioned protective film forming agent.

The shape of a processed surface of the semiconductor wafer is not particularly limited so long as the desired processing can be conducted on the semiconductor wafer. Typically, the processed surface of the semiconductor wafer has many surface irregularities. Then, a recessed part is formed in a region corresponding to a street. In the processed surface of the semiconductor wafer, a plurality of regions corresponding to semiconductor chips are demarcated by the streets. Since the protective film is easily removed by water washing after processing, and the protective film has sufficient durability to plasma irradiation in the case of performing plasma irradiation in the cutting step described later, typically, the thickness of the protective film is preferably 0.1 µm or more and 100 µm or less, and more preferably 1 µm or more and 100 µm or less. In the case of laser irradiation in the processed groove forming step, the thickness of the protective film is preferably 0.1 µm or more and 30 µm or less.

Hereinafter, about a manufacturing method of semiconductor chips, in which using the aforementioned protective film forming agent, dicing processing is performed on a semiconductor wafer including a plurality of semiconductor chips demarcated by a lattice of streets, a preferred aspect of the manufacturing method of semiconductor chips will be explained with reference to the drawings.

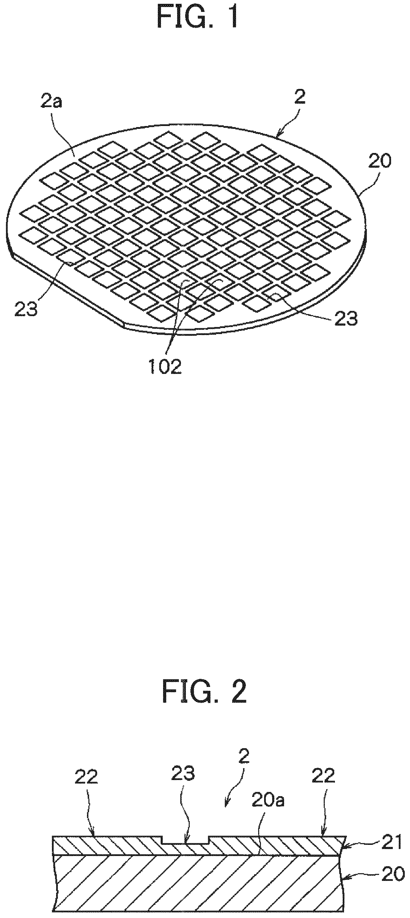

FIG. 1 shows a perspective view of a semiconductor wafer as a processing target. FIG. 2 shows an enlarged cross-sectional view of a main part of the semiconductor wafer shown in FIG. 1. In the semiconductor wafer 2 shown in FIGS. 1 and 2, a laminate 21 in which a functional film forming an insulating film and circuit are laminated is provided on the surface 20a of a semiconductor substrate 20 such as silicon. In the laminate 21, a plurality of semiconductor chips 22 such as IC and LSI are formed in a matrix shape. Herein, the shape and size of the semiconductor chips 22 are not particularly limited, and can be appropriately set according to the design of the semiconductor chip 22.

Each of the semiconductor chips 22 is demarcated by the streets 23 formed in a lattice shape. It should be noted that, in the illustrated embodiment, the insulating film used as the laminate 21 consists of a SiO₂ film, or a low-dielectric constant insulating film (Low-k film) consisting of an inorganic film such as SiOF or BSG (SiOB), or an organic film, which is a polymer film such as of polyimide type or parylene type.

The surface of the above laminate 21 corresponds to the surface 2a which is the processed surface. The protective film is formed on the above surface 2a using the aforementioned protective film forming agent.

In the protective film forming step, for example, the protective film is formed by coating the protective film forming agent on the surface 2a of the semiconductor wafer 2 by a spin coater. It should be noted that the coating method of the protective film forming agent is not particular limited so long as a protective film of a desired thickness can be formed.

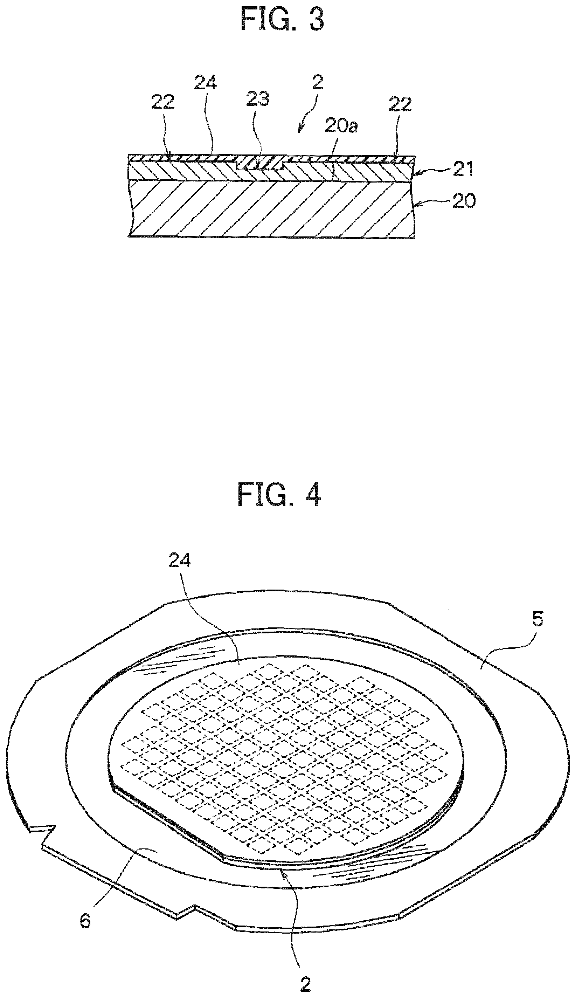

Next, the protective film forming agent in a liquid form coating the surface 2a is dried. A protective film 24 is thereby formed on the surface 2a of the semiconductor wafer 2 as shown in FIG. 3.

After the protective film 24 is formed on the surface 2a of the semiconductor wafer 2 in this way, protective tape 6 put onto an annular frame 5 is pasted on the back surface of the semiconductor wafer 2, as shown in FIG. 4.

### <Processed Groove Forming Step>

In the processed groove forming step, a predetermined position of one or more layers including the protective film 24 on the semiconductor wafer 2 is irradiated with a laser beam to expose the surface 20a of the semiconductor substrate 20, whereby the processed groove with a pattern according to the shape of the semiconductor chip 22 is formed.

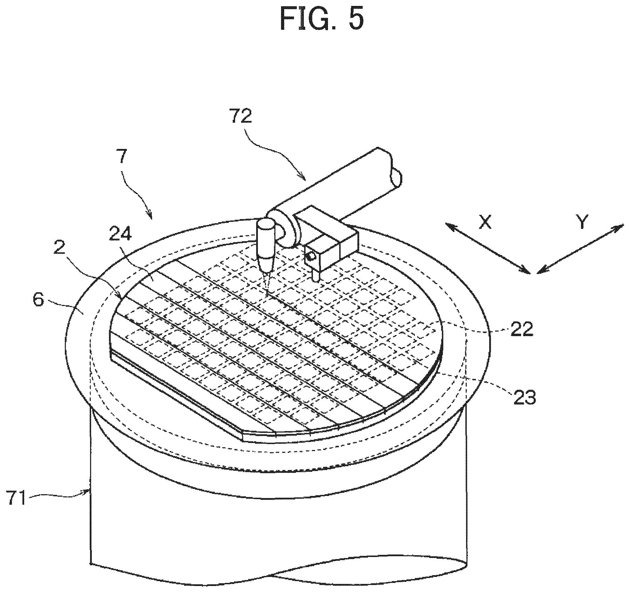

Specifically, the surface 2a (street 23) of the semiconductor wafer 2 is irradiated with a laser beam through the protective film 24. This laser beam irradiation is carried out using a laser beam irradiation means 72 as shown in FIG. 5. The laser is preferably an ultraviolet laser having a wavelength of 100 nm or more and 400 nm or less because of the intensity. In addition, a YVO4 laser and YAG laser with a wavelength of e.g. 266 nm or 355 nm are preferable.

The above laser beam irradiation in the processed groove forming step is performed on the following processing conditions, for example. It should be noted that the light collecting spot diameter is appropriately selected considering the width of the processed groove 25. Light source of laser
beam: YVO4 laser or YAG laser,
Wavelength: 355 nm,
Repetition frequency: 50 kHz or more and 100 kHz or less,
Output: 0.3 W or more and 4.0 W or less,
Process feed rate: 1 mm/s or more and 800 mm/s or less.

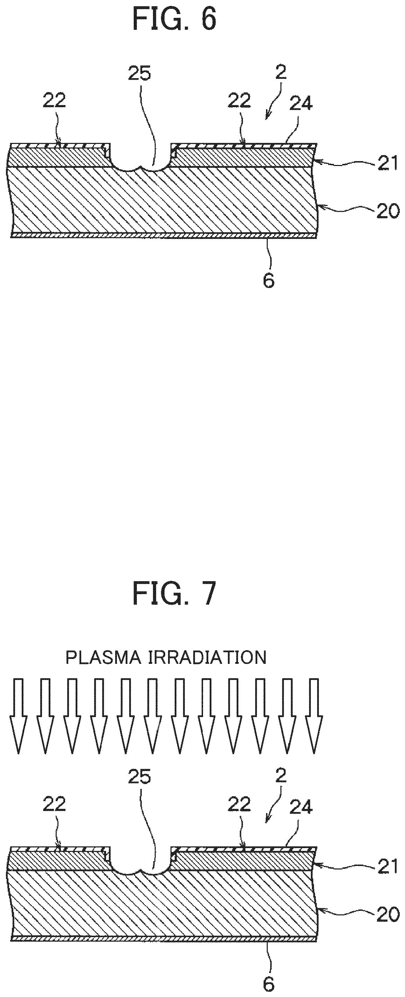

By carrying out the above-described processed groove forming step, the processed groove 25 is formed along the street 23 in the laminate 21 including the street 23 in the semiconductor wafer 2, as shown in FIG. 6. When the protective film 24 is formed of the protective film forming agent including the water-soluble resin (A1) having an aromatic ring and a water-soluble group, by irradiating the protective film 24 with a laser beam as described above, a groove (the processed groove 25) having a cross section with excellent straightness can be formed in the protective film 24.

Laser beam irradiation along predetermined streets 23 is carried out as described above, and the semiconductor wafer 2 retained on a chuck table 71 is then indexed by intervals of the streets in the direction indicated by the arrow Y, and laser beam irradiation is carried out again.

After laser beam irradiation and indexing along all the streets 23 extending in a predetermined direction as described above, the semiconductor wafer 2 retained on the chuck table 71 is rotated by 90 degrees, and the laser beam irradiation and indexing are carried out in the same manner as above along each street 23 extending at a right angle relative to the above predetermined direction. In this way, it is possible to form the processed grooves 25 along all the streets 23 formed in the laminate 21 on the semiconductor wafer 2.

### <Cutting Step>

In the cutting step, the semiconductor wafer 2 having the processed groove 25 at a position corresponding to the position of the street 23 is cut. As a preferable method, a method of cutting the semiconductor wafer 2 by radiating plasma to the semiconductor wafer 2 including the protective film 24 and the processed groove 25 can be mentioned. When the plasma is radiated, a part or the entirety of the surface of the semiconductor wafer 2 provided with a protective film is irradiated with plasma so that the surface of the processed groove 25 is exposed to the plasm. Hereinafter, the cutting method by plasma irradiation will be described.

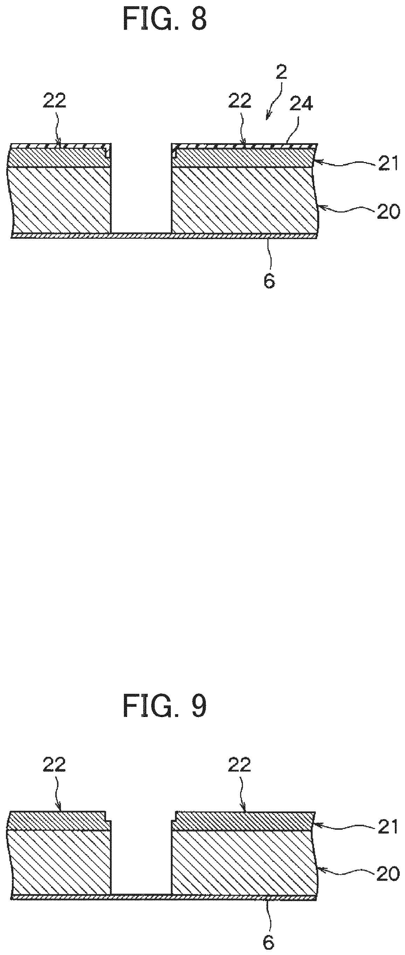

As shown in FIG. 7, the semiconductor wafer 2 including the protective film 24 and processed groove 25 is irradiated with plasma. By doing this, the position of the processed groove 25 in the semiconductor wafer 2 is cut as shown in FIG. 8. Specifically, in the semiconductor wafer 2 coated by the protective film 24, after forming the processed groove 25 as described above, the semiconductor wafer 2 is cut according to the shape of the semiconductor chips 22 by irradiating the protective film 24 and the surface 20a of the semiconductor substrate 20 exposed from the processed groove 25 with plasma to divide the semiconductor wafer 2 into the semiconductor chips 22.

The plasma irradiation conditions are not particularly limited so long as the semiconductor wafer 2 can be favorably cut at the position of the processed groove 25. The plasma irradiation conditions are appropriately set within a range of common conditions of plasma etching on a semiconductor substrate 20, considering e.g. the material of the semiconductor wafer 2, and plasma type. The gas used to generate plasma in the plasma irradiation is appropriately selected according to the material of the semiconductor wafer 2. Typically, SF₆ gas is used to generate plasma. In addition, by alternately performing sidewall protection by the supply of e.g. C₄F₆ or C₄F₈ gas, and etching of the semiconductor wafer 2 by plasma irradiation in accordance with the so-called BOSCH process, the semiconductor wafer 2 may be cut. According to the BOSCH process, etching with a high-aspect ratio is possible, and even in a case of the semiconductor wafer 2 being thick, the semiconductor wafer 2 is easily cut.

As described above, in the plasma irradiation, a fluorine-based gas is generally used. For this reason, there is a problem that the semiconductor substrate 20 may be contaminated by the fluorine transmitted through the protective film during the plasma etching process. When the protective film 24 is formed of the protective film forming agent containing the water-soluble resin (A1) having an aromatic ring and a water-soluble group, the protective film 24 has excellent fluorine shielding property. Therefore, the fluorine-based gas can be prevented from passing through the protective film during the plasma irradiation, and contamination of the semiconductor substrate due to fluorine can be suppressed.

When the protective film 24 is formed of the protective film forming agent containing the water-soluble resin (A1) having an aromatic ring and a water-soluble group, the processed groove 25 has a cross section having excellent straightness. Therefore, a semiconductor chip having excellent straightness can be obtained by plasma irradiation.

Next, as shown in FIG. 9, the protective film 24 that covers the surface of the semiconductor chip 22 is removed. As described above, since the protective film 24 is formed using the protective film forming agent containing the water-soluble resin (A), the protective film 24 can be washed away by water (or warm water). When the protective film 24 is formed of the protective film forming agent described above, since the protective film 24 has excellent fluorine shielding property, a semiconductor chip in which an amount of fluorine is suppressed can be obtained by washing off the protective film 24.

The manufacturing method of semiconductor chips by processing a semiconductor wafer has been explained above based on the embodiment as described above. The protective film forming agent and manufacturing method of semiconductor chips according to the present invention can be applied to manufacturing methods of various semiconductor chips so long as being a method including forming a protective film on the semiconductor wafer surface, and forming a processed groove at a position corresponding to a street in the surface including the protective film of the semiconductor wafer.

### [Examples 1 to 16 and Comparative Examples 1 to 4]

In the Examples and the Comparative Examples, as the water-soluble resin (A), Resin-A1 to Resin-A8 as the water-soluble resin (A1) having an aromatic ring and a water-soluble group, Resin-A9 as the cellulose-based resin, and Resin-A10 as the vinyl-based resin were used. The number at the lower right of the parentheses in each constituent unit in the following structural formula represents the molar ratio of the constituent unit in each resin. Resin-A1 is WSR-SP82 manufactured by Konishi Chemical Ind. Co., Ltd. and has a mass average molecular weight of 22,000. Resin-A2 is WSR-SP28 manufactured by Konishi Chemical Ind. Co., Ltd. and has a mass average molecular weight of 20,000. Resin-A3 is a sodium hydroxide neutralized product (pH 8.8) of PSA-R manufactured by Konishi Chemical Ind. Co., Ltd. and has a mass average molecular weight of 21,000. Resin-A4 is an ammonia neutralized product (pH 8.6) of PSA-R manufactured by Konishi Chemical Ind. Co., Ltd. and has a mass average molecular weight of 21,000. Resin-A5 is a sodium hydroxide neutralized product (pH 7.2) of VERSA-TL 72 manufactured by Akzo Nobel N.V., and has a mass average molecular weight of 75,000. Resin-A6 is an ammonia neutralized product (pH 7.2) of VERSA-TL 72 manufactured by Akzo Nobel N.V. and has a mass average molecular weight of 75,000. Resin-A7 is VERSA-TL 125 manufactured by Akzo Nobel N.V. and has a mass average molecular weight of 200,000. Resin-A8 is NARLEX D72 manufactured by Akzo Nobel N.V. and has a mass average molecular weight of 20,000. Resin-A9 is HPC-SSL (hydroxypropyl cellulose) manufactured by NIPPON SODA Co., Ltd. and has a mass average molecular weight of 40,000. Resin-A10 is Pitscol K-90 (polyvinylpyrrolidone) manufactured by DKS Co., Ltd. and has a mass average molecular weight of 1,200,000.

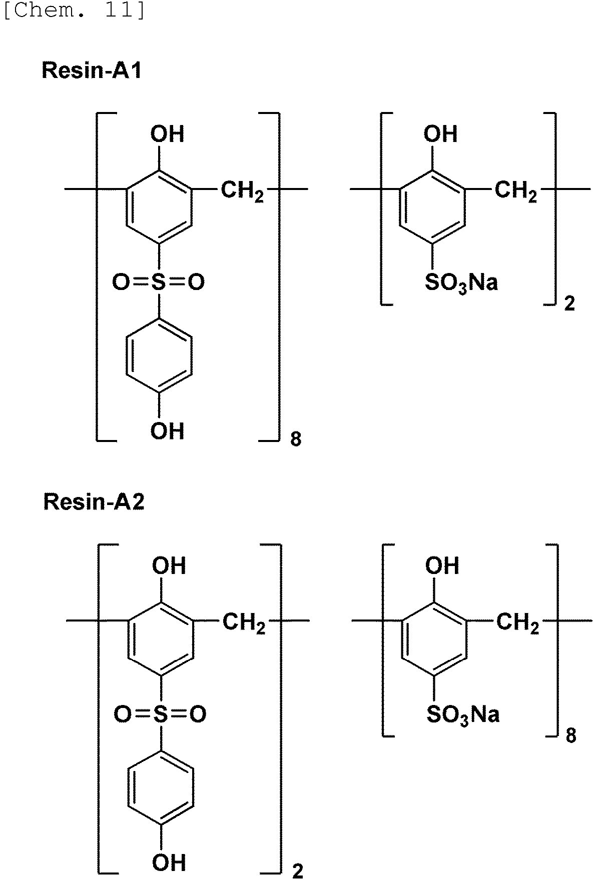

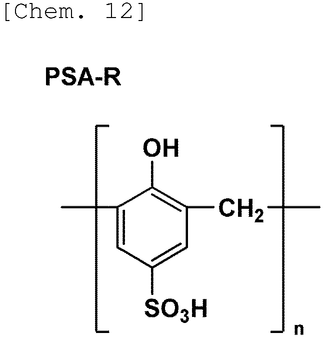

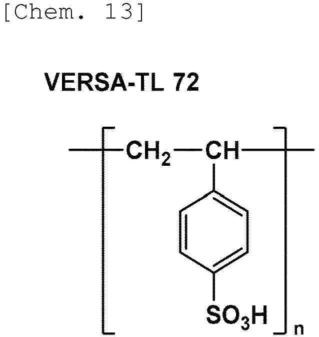

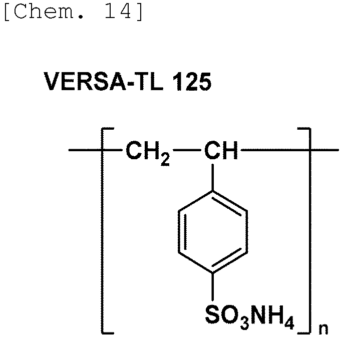

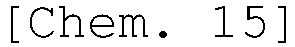

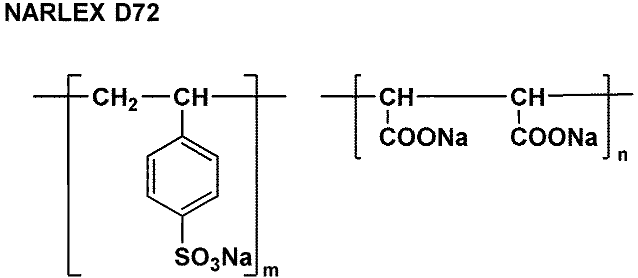

In the Examples and the Comparative Examples, compound B1 represented by the following formula was used as the light absorbing agent (B).

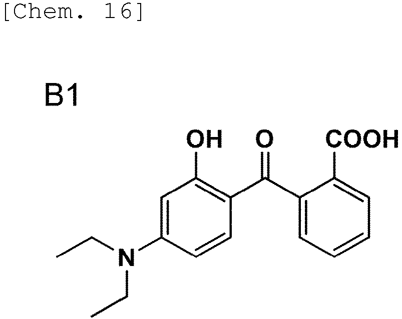

The type and parts by mass described in Tables 1 to 3 of water-soluble resins (A), the type and parts by mass described in Tables 1 to 3 of the compound B1 as the light absorbing agent (B), parts by mass described in Tables 1 to 3 of monoethanolamine as the basic compound (C), and the solvent (S) were added into a container so as to have solid content concentrations shown in Tables 1 to 3, and stirred for 3 hours to obtain protective film-forming agents of the Examples and the Comparative Examples. The solid content concentration was determined by dividing a total mass of the water-soluble resin (A), the light absorbing agent (B), and the basic compound (C) by the sum of the water-soluble resin (A), the light absorbing agent (B), the basic compound (C), and the solvent (S). As the solvent (S), a mixed solvent composed of 85 parts by mass of water and 15 parts by mass of propylene glycol monomethyl ether was used.

### [Evaluation of Film Forming Property]

Each resultant protective film forming agent was applied onto a silicon substrate by a spin coating method in order for a protective film to have a thickness shown in Tables 1 to 3, thereby forming the coating film. Each coating film formed was visually observed, and the film forming property was evaluated by rating a case where cracks occurred as poor (indicated by cross symbol(x)), and a case where a good coating film without cracks was formed as good (indicated by circle symbol(o)). The results are shown in Tables 1 to 3.

### [Evaluation of Straightness (Laser Workability) of Processed Grooves]

Each protective film forming agent obtained was applied onto a silicon substrate by a spin coating method in order for a protective film to have a thickness shown in Tables 1 to 3, thereby forming the protective film. A surface in the protective film side of the silicon substrate provided with the protective film was linearly irradiated with laser beams under the following conditions, and the cross-sectional shape of the part of the protective film irradiated with the laser was observed with an SEM (scanning electron microscope) and evaluated according to the evaluation criteria described later. The results are shown in Tables 1 to 3.

### <Laser Irradiation Conditions>

Wavelength: 355 nm
Frequency: 100 kHz
Output: 0.3 W
Defocus: -0.4 mm
Feed speed: 100 mm/s
Pass: 3

### <Cross-Sectional Shape Evaluation Criteria>

∘: The cross section of the protective film was flat, and a straight clean trench (groove) was formed.
×: A trench having irregularities was formed in the cross section of the protective film.

### [Evaluation of Fluorine Shielding Property]

Each resultant protective film forming agent was applied on an aluminum substrate in order for a protective film to have a thickness shown in Tables 1 to 3 by a spin coating method to form the protective film. A surface in the protective film side of the aluminum substrate provided with the protective film was linearly irradiated with a laser beam under the same conditions as those of the "[Evaluation of Straightness (Laser Workability) of Processed Grooves]" to form the processed groove. Next, after the plasma irradiation, the protective film was removed by washing with water. In the plasma irradiation, plasmas of SF₆ gas and C₄F₈ gas were alternately radiated for 100 cycles in the BOSCH process. A surface of the aluminum substrate after the washing was analyzed by X-ray photoelectron spectroscopy (XPS: X-ray Photoelectron Spectroscopy), and the fluorine shielding property was evaluated by rating a case where a value of fluorine atom/oxygen atom (F/O ratio) was less than 0.10 as excellent (indicated by bullseye symbol (⊙)), rating a case where the F/O ratio was 0.10 or more and less than 0.20 as good (indicated by circle symbol (O)), and rating a case where the F/O ratio was 0.20 or more as poor (indicated by cross symbol (X)). The results are shown in Tables 1 to 3.

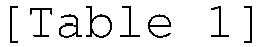

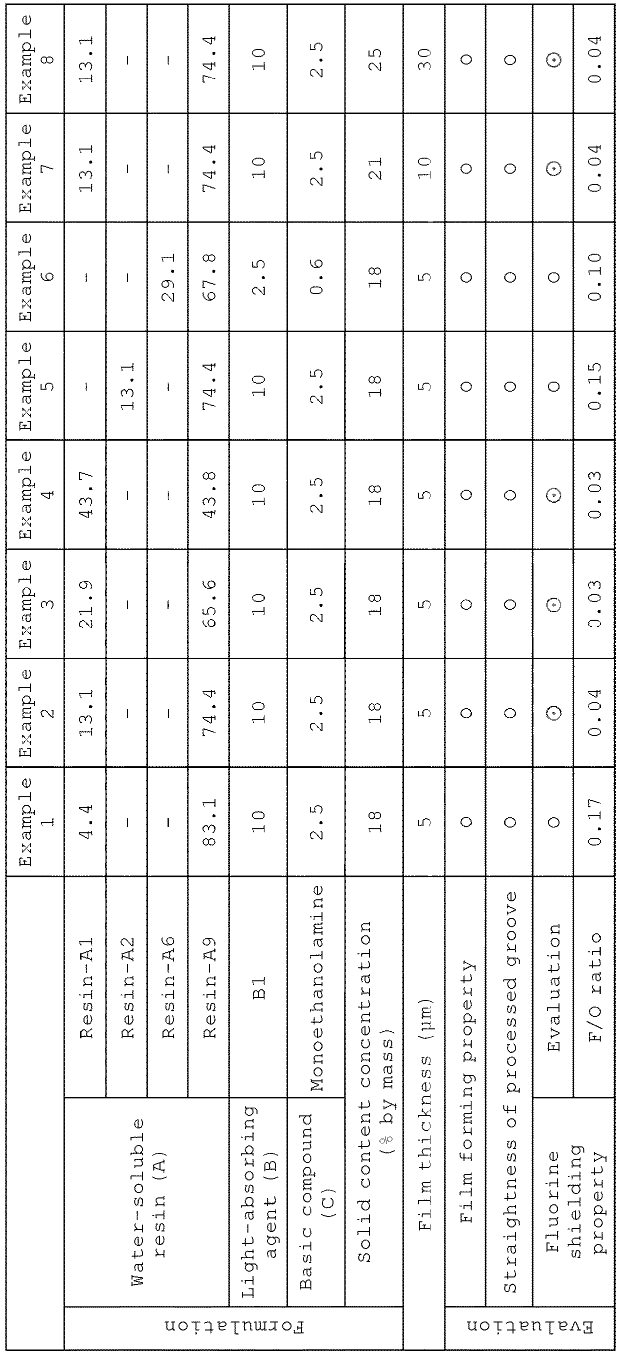

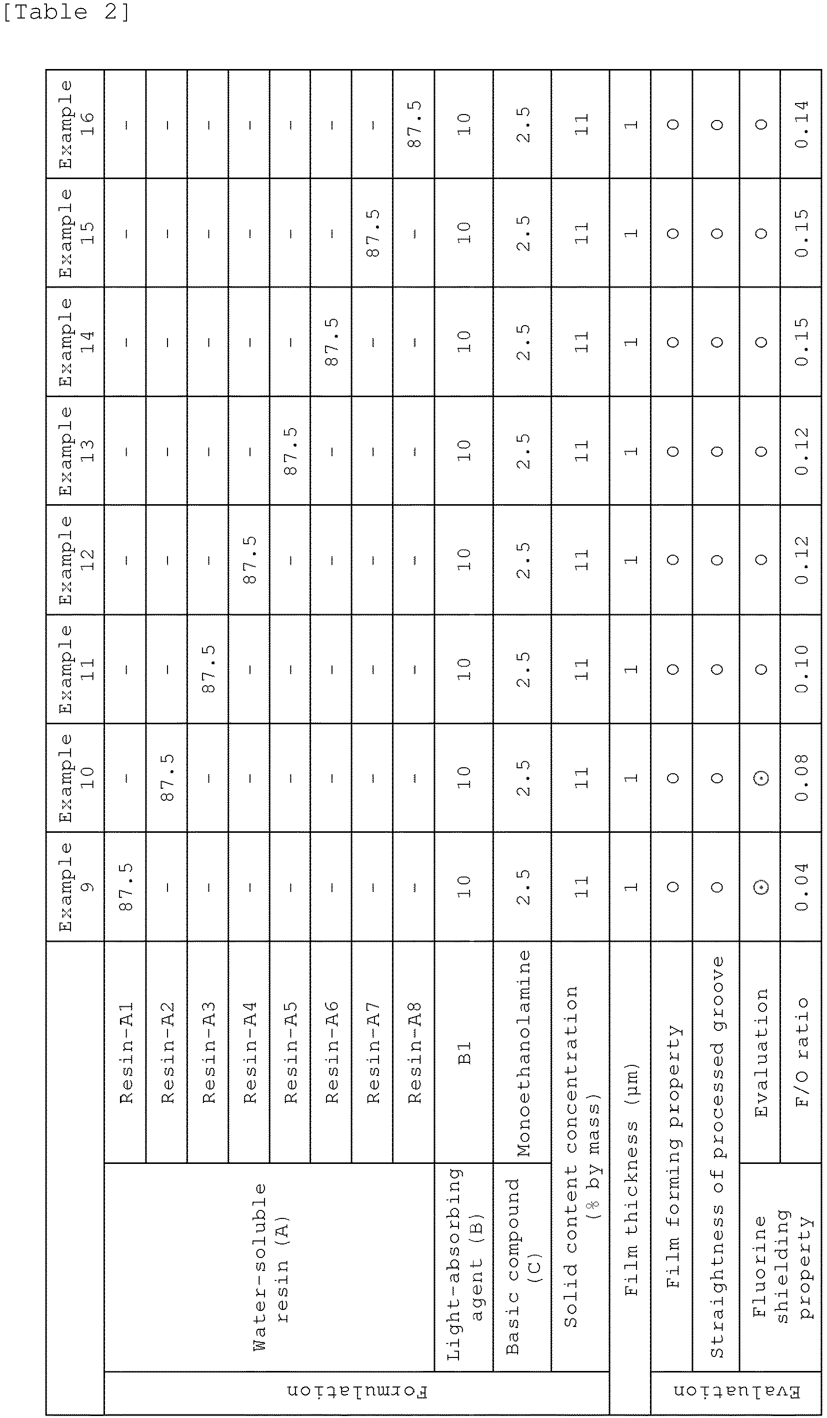

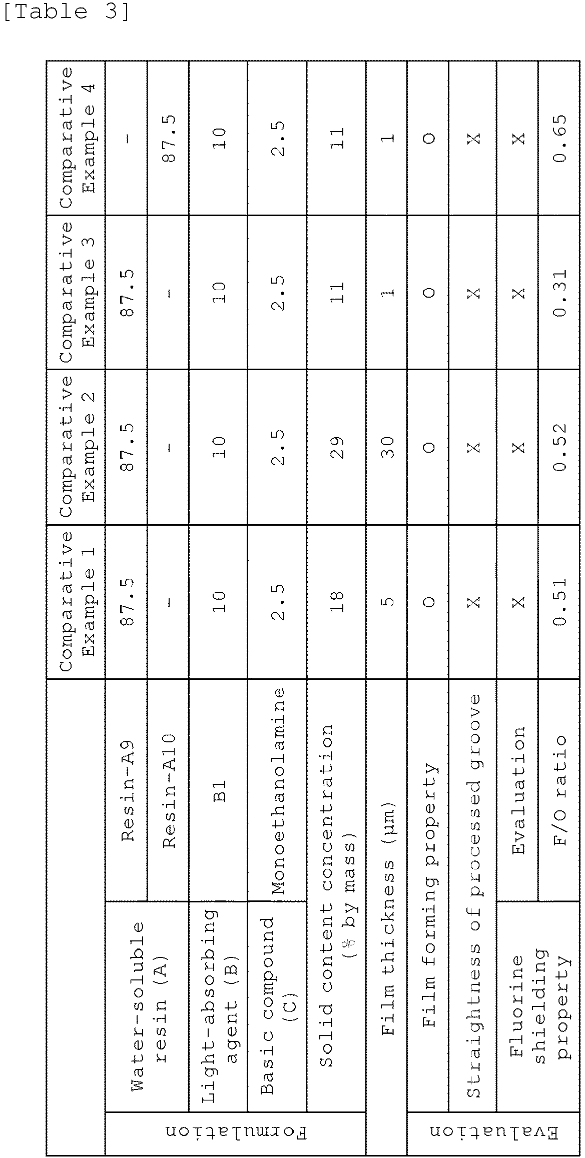

As shown in Tables 1 to 3, it can be understood that the protective film in which the protective film 24 was formed by using the protective film forming agent containing a water-soluble resin (A1) having an aromatic ring and a water-soluble group allowed a processed groove having excellent straightness to be formed by a laser beam and had excellent fluorine shielding property.

2 Semiconductor wafer
20 Substrate
21 Laminate
22 Semiconductor chip
23 Street
24 Protective film
25 Laser processed groove
26 Cut groove
3 Spin coater
5 Annular frame
6 Protective tape
7 Laser processing device
71 Chuck table of laser processing device
72 Laser beam irradiation means

## Claims

1. A protective film forming agent for forming a protective film on a surface of a semiconductor wafer in dicing the semiconductor wafer,
the protective film forming agent comprising a water-soluble resin A, a light absorbing agent B, and a solvent S,
the water-soluble resin A comprising a water-soluble resin A1,
the water-soluble resin A1 having an aromatic ring and a water-soluble group, wherein the water-soluble resin A1 is a phenol resin or a polystyrene resin, and the light absorbing agent B includes a compound represented by the following formula B1: 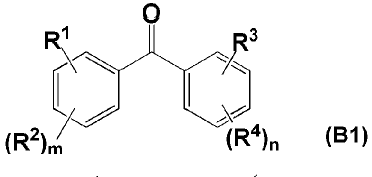
, in formula B1,
R¹ and R³ are each independently a hydroxy group or a carboxy group, R² and R⁴ are each independently a hydroxy group, a carboxy group or a group represented by -NR⁵R⁶, R⁵ and R⁶ are each independently a hydrogen atom or an alkyl group having 1 or more and 4 or less carbon atoms, and m and n are each independently an integer of 0 or more and 2 or less.

2. The protective film forming agent according to claim 1 , wherein the water-soluble resin A comprises a cellulose-based resin.

3. The protective film forming agent according to any one of claims 1 or 2, wherein the protective film forming agent comprises the water-soluble resin A1 in a content of 1% by mass or more and 60% by mass or less with respect to a total solid content.

4. The protective film forming agent according to any one of claims 1 to 3, wherein the solvent S comprises an organic solvent and water.

5. A method of manufacturing a semiconductor chip by processing a semiconductor wafer, the method comprising:
forming a protective film by coating the semiconductor wafer with the protective film forming agent according to any one of claims 1 to 4, and
irradiating a predetermined position of one or more layers comprising the protective film on the semiconductor wafer with a laser beam to expose a surface of the semiconductor wafer, and to form a processed groove with a pattern according to a shape of the semiconductor chip.

## Patentansprüche

1. Schutzfilm-bildendes Mittel zum Bilden eines Schutzfilms auf einer Oberfläche eines Halbleiterwafers bei einem Zerschneiden des Halbleiterwafers,
wobei das Schutzfilm-bildende Mittel ein wasserlösliches Harz A, ein Lichtabsorptionsmittel B und ein Lösungsmittel S umfasst,
das wasserlösliche Harz A ein wasserlösliches Harz A1 umfasst,
das wasserlösliche Harz A1 einen aromatischen Ring und eine wasserlösliche Gruppe aufweist,
wobei das wasserlösliche Harz A1 ein Phenolharz oder ein Polystyrolharz ist, und
das lichtabsorbierende Mittel B eine Verbindung umfasst, dargestellt durch die folgende Formel
B1: 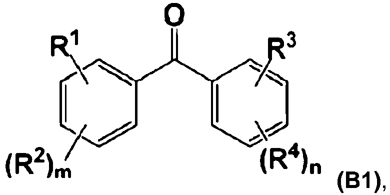
wobei in Formel B1 R¹ und R³ jeweils unabhängig eine Hydroxygruppe oder eine Carboxygruppe sind, R² und R⁴ jeweils unabhängig eine Hydroxygruppe, eine Carboxygruppe oder eine durch -NR⁵R⁶ dargestellte Gruppe sind, R⁵ und R⁶ jeweils unabhängig ein Wasserstoffatom oder eine Alkylgruppe mit 1 oder mehr und 4 oder weniger Kohlenstoffatomen sind und m und n jeweils unabhängig eine ganze Zahl von 0 oder mehr und 2 oder weniger sind.

2. Schutzfilm-bildendes Mittel nach Anspruch 1, wobei das wasserlösliche Harz A ein Harz auf Cellulosebasis umfasst.

3. Schutzfilm-bildendes Mittel nach einem der Ansprüche 1 oder 2, wobei das Schutzfilm-bildende Mittel das wasserlösliche Harz A1 in einem Gehalt von 1 Massenprozent oder mehr und 60 Massenprozent oder weniger, in Bezug auf einen Gesamtfeststoffgehalt, umfasst.

4. Schutzfilm-bildendes Mittel nach einem der Ansprüche 1 bis 3, wobei das Lösungsmittel S ein organisches Lösungsmittel und Wasser umfasst.

5. Verfahren zum Herstellen eines Halbleiterchips durch Verarbeiten eines Halbleiterwafers, wobei das Verfahren umfasst:
Bilden eines Schutzfilms durch Beschichten des Halbleiterwafers mit dem Schutzfilmbildenden Mittel nach einem der Ansprüche 1 bis 4 und
Bestrahlen einer vorbestimmten Position einer oder mehrerer Schichten, welche den Schutzfilm auf dem Halbleiterwafer umfassen, mit einem Laserstrahl, um eine Oberfläche des Halbleiterwafers freizulegen und um eine verarbeitete Nut mit einem Muster entsprechend einer Form des Halbleiterchips zu bilden.

## Revendications

1. Agent de formation de film protecteur pour former un film protecteur sur une surface d'une plaque semi-conductrice en découpant la plaque semi-conductrice,
l'agent de formation de film protecteur comprenant une résine soluble dans l'eau A, un agent absorbant la lumière B, et un solvant S,
la résine soluble dans l'eau A comprenant une résine soluble dans l'eau A1,
la résine soluble dans l'eau A1 ayant un cycle aromatique et un groupe soluble dans l'eau,
dans lequel la résine soluble dans l'eau A1 est une résine phénolique ou une résine de polystyrène, et
l'agent absorbant la lumière B inclut un composé représenté par la formule B1 suivante : 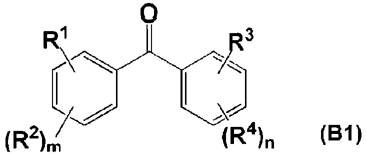 , dans la formule B1,
R¹ et R³ sont chacun indépendamment un groupe hydroxyle ou un groupe carboxyle, R² et R⁴ sont chacun indépendamment un groupe hydroxyle, un groupe carboxyle ou un groupe représenté par -NR⁵R⁶, R⁵ et R⁶ sont chacun indépendamment un atome d'hydrogène ou un groupe alkyle ayant 1 ou plus et 4 ou moins atomes de carbone, et m et n sont chacun indépendamment un entier valant 0 ou plus et 2 ou moins.

2. Agent de formation de film protecteur selon la revendication 1, dans lequel la résine soluble dans l'eau A comprend une résine à base de cellulose.

3. Agent de formation de film protecteur selon l'une quelconque des revendications 1 ou 2, dans lequel l'agent de formation de film protecteur comprend la résine soluble dans l'eau A1 en une teneur de 1 % en masse ou plus et de 60 % en masse ou moins rapportée à une teneur en matière sèche totale.

4. Agent de formation de film protecteur selon l'une quelconque des revendications 1 à 3, dans lequel le solvant S comprend un solvant organique et de l'eau.

5. Procédé de fabrication d'une puce semi-conductrice par traitement d'une plaque semi-conductrice, le procédé comprenant :
la formation d'un film protecteur en revêtant la plaque semi-conductrice par l'agent de formation de film protecteur selon l'une quelconque des revendications 1 à 4, et
l'irradiation d'une position prédéterminée d'une ou de plusieurs couches comprenant le film protecteur sur la plaque semi-conductrice à l'aide d'un faisceau laser afin d'exposer une surface de la plaque semi-conductrice et de former une rainure traitée avec un motif selon une forme de la puce semi-conductrice.
